# DEMANDE DE BREVET EUROPEEN

(11) **EP 1 030 353 A1**
(43) Date de publication de la demande: **23.08.2000**
(21) Numéro de dépôt: 00400363.8
(22) Date de dépôt: 09.02.2000
(51) Int. Cl.: H01L 21/311, H01L 21/768

(54) **Procédé de gravure anisotrope par plasma gazeux d'un matériau polymère diélectrique organique**

(30) Priorité: 17.02.1999 FR 9901925
(71) Demandeur: FRANCE TELECOM, 75015 Paris (FR)
(72) Inventeur: Joubert, Olivier, 38240 Meylan (FR); Fuard, David, 45700 Villemandeur (FR)
(74) Mandataire: Casalonga, Axel

(57) **Abrégé**

Le procédé selon l'invention consiste à graver un matériau polymère organique diélectrique au moyen d'un plasma dont la phase gazeuse est constituée de O₂/NH₃, O₂/H₂O, O₂/CH₄ ou O₂/H₂.

Application à la gravure des lignes et trous d'interconnexion des circuits intégrés.

## Description

La présente invention concerne de manière générale un procédé de gravure anisotrope d'une couche d'un matériau polymère diélectrique au moyen d'un plasma à base d'oxygène.

A l'heure actuelle, les interconnexions en microélectronique à base de silicium sont réalisées en utilisant de l'aluminium pour former les lignes de métal et de l'oxyde de silicium (SiO₂) comme diélectrique d'isolation entre les lignes de métal. Cependant, la réduction des dimensions des circuits intégrés, et donc l'accroissement de la vitesse de fonctionnement des dispositifs, impose une modification importante de la stratégie de formation des interconnexions, sous peine de voir la vitesse de fonctionnement du dispositif limitée par le temps de propagation des signaux dans les interconnexions.

Pour résoudre ce problème, il est alors nécessaire de remplacer l'aluminium par un matériau conducteur de plus faible résistivité, par exemple du cuivre, et l'oxyde de silicium par un matériau diélectrique ayant une constante diélectrique plus faible.

Il existe une grande variété de matériaux ayant une constante diélectrique plus faible que SiO₂ (qui a une constante diélectrique de l'ordre de 4 aux fréquences utilisées pour les applications envisagées). Une classe particulièrement intéressante de matériaux présentant une faible constante diélectrique, sont les matériaux polymères diélectriques, en particulier les matériaux polymères diélectriques purement organiques. Un exemple de matériau polymère approprié est le matériau commercialisé par la Société DOW CHEMICAL sous la dénomination SILK® qui a une constante diélectrique de l'ordre de 2,6.

Afin de réaliser les lignes métalliques d'interconnexion en utilisant comme matériau d'isolation entre les lignes de tels matériaux polymères diélectriques, il est nécessaire de réaliser en premier lieu sur une couche du matériau polymère diélectrique, par photolithographie classique, un masque dur, par exemple d'oxyde de silicium SiO₂, définissant les dimensions et formes des lignes et trous d'interconnexion, puis de graver dans la couche de matériau polymère le motif de lignes et de trous. On procède ensuite au remplissage des lignes et trous gravés avec un métal tel que le cuivre, puis comme cela est classique, à une planarisation de la structure obtenue par polissage mécano-chimique (PMC).

L'étape de gravure est une opération essentielle du procédé de fabrication des circuits intégrés et doit permettre d'obtenir des flancs de gravure aussi droits que possible (gravure anisotrope).

En outre, pour bien comprendre les problèmes liés à l'étape de gravure, il est important d'avoir en mémoire que le couple Cuivre/Matériau polymère diélectrique est étroitement lié à l'utilisation du procédé dit "damascène" qui permet de définir et réaliser simultanément les lignes et trous.

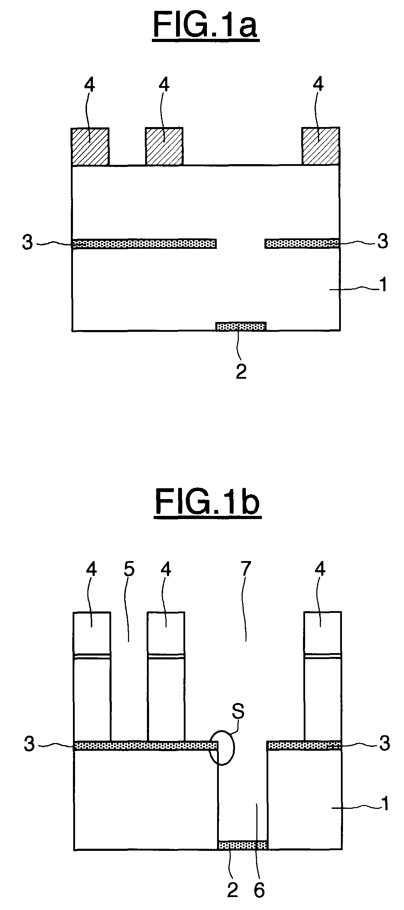

Ce procédé dit "damascène" est schématisé aux figures 1a à 1d.

La figure 1a représente une structure "damascène" classique avant gravure des lignes et des trous d'interconnexion.

Comme le montre la figure 1a, cette structure comprend au sein de la couche de matériau polymère organique 1, des couches d'arrêt 1 et 2, par exemple en oxyde SiO₂, configurées et disposées pour la réalisation de trous et lignes d'interconnexion.

Après formation d'un masque dur 4 de motif approprié, on procède à la gravure des trous 5, 6 et de la ligne 7 d'interconnexion comme représentés figure 1b.

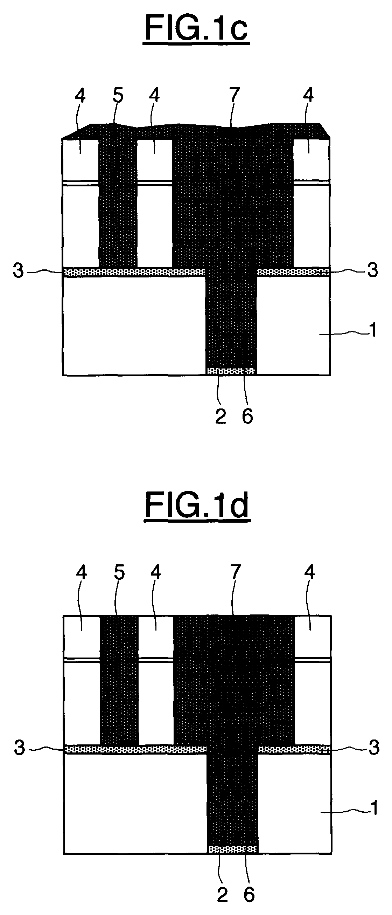

L'étape suivante est le dépôt de métal (par exemple Cu) dans les trous 5, 6 et la ligne 7 (figure 1c) et la planarisation de la structure (figure 1d). Pour ce dépôt du métal, on peut utiliser toute méthode classique, par exemple un dépôt en phase vapeur (CVD).

On constate d'après la figure 1b, que la ligne 7 et les trous 5, 6 doivent être gravés simultanément, ce qui complique l'opération de gravure puisque les facteurs de forme mis en jeu sont importants. Par ailleurs, le procédé de gravure doit permettre d'obtenir une sélectivité de gravure importante entre le matériau polymère et la couche 1, par exemple à l'intersection (S) entre la ligne 8 et le trou 7.

La gravure des lignes et trous est classiquement réalisée au moyen d'un plasma d'oxygène qui permet à la fois des vitesses de gravure élevées avec une directivité importante et contrôlée suivant la normale à la surface du substrat gravé.

Les cinétiques observées dans les plasmas sont généralement attribuées d'une part, à un phénomène de dissociation du gaz réactif à l'origine de la production d'espèces atomiques réactives et, d'autre part, à l'ionisation du gaz qui produit des ions positifs permettant le bombardement ionique, normal à la surface du substrat, porté à un potentiel négatif par rapport au potentiel du plasma.

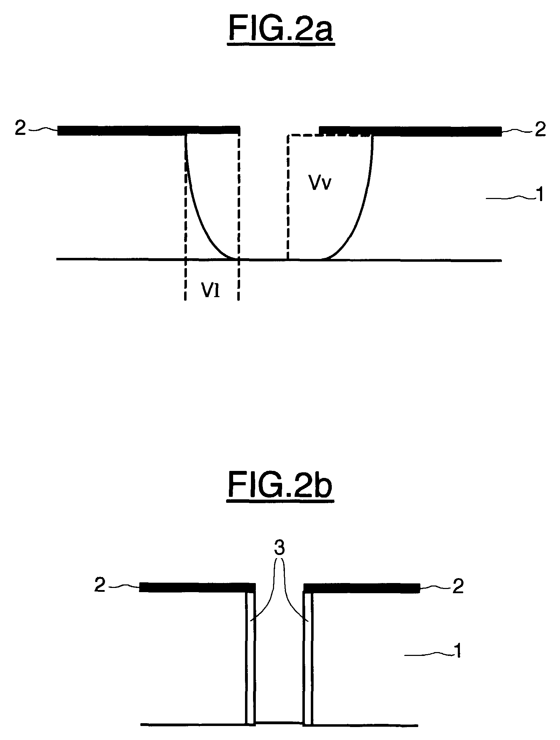

On va maintenant décrire, en se référant aux figures 2a et 2b, l'opération de gravure par plasma proprement dite d'une couche d'un matériau polymère.

L'action de la gravure par plasma d'une couche 1 de matériau polymère au moyen d'un masque dur 2, peut être décomposée en une vitesse de gravure verticale Vᵥ de direction normale à la couche 1 et une vitesse de gravure latérale V₁ spontanée, dirigée vers les flancs de gravure non soumis au bombardement ionique. Comme le montre la figure 2a, la gravure du matériau polymère 1 présente un profil de gravure isotrope dû à l'action de la gravure latérale Vₗ.

En pratique, pour obtenir un profil de gravure anisotrope, il faut augmenter le flux d'ions bombardant le substrat par rapport au flux d'espèces réactives responsable de la gravure spontanée des flancs de gravure.

La très forte réactivité des polymères avec les atomes neutres d'oxygène présents dans un plasma d'oxygène rend très difficile l'utilisation de plasmas d'oxygène pur (quand la température du substrat est maintenue proche de 20°C). Les profils de gravure des polymères obtenus en plasma d'oxygène ne sont pas anisotropes, quelles que soient les conditions plasma utilisées. On observe souvent des profils de gravure comme celui représenté figure 2a. Pour éviter l'apparition de la gravure latérale, il serait souhaitable d'utiliser une chimie de gravure, en particulier à base d'oxygène qui, associée aux conditions plasma, permette, comme le montre la figure 2b, la formation d'une couche de passivation 3 sur les flancs du trou ou de la ligne gravée dans la couche de matériau polymère 1. Cette couche de passivation 3 doit permettre de bloquer les réactions de gravure latérale spontanée du polymère et donc d'obtenir une gravure anisotrope.

En gravure par plasma, une couche de passivation est formée à partir de composés pas ou peu volatils qui sont issus, soit de la décomposition des gaz de gravure, soit à partir des produits de réaction de la gravure. Ces produits peu volatils sont déposés sur les flancs du matériau depuis la phase gazeuse du plasma (quand ils sont issus de la décomposition du gaz de gravure) ou sont issus de la pulvérisation de la couche réactive par le bombardement ionique du plasma. Dans ce dernier cas, le bombardement ionique favorise la formation de produits de réaction de gravure peu volatils et les pulvérise sur les flancs des motifs. Quel que soit le mécanisme de formation des produits peu volatils (décomposition du gaz de gravure ou pulvérisation de la couche réactive), les produits non volatils ne s'accumulent que sur les surfaces non bombardées des motifs (les flancs de gravure).

Comme indiqué précédemment, dans un procédé de type damascène, l'étape de gravure du matériau polymère est suivie d'une étape de dépôt d'un métal tel que le cuivre ou éventuellement l'aluminium. Le métal est donc en contact avec les flancs du polymère et en particulier avec la couche de passivation. Il est donc primordial que la couche de passivation soit chimiquement inerte vis-à-vis du métal. En particulier, on doit éviter les réactions de corrosion entre le métal et la couche de passivation.

Par suite, il est nécessaire que la phase gazeuse du plasma de gravure soit exempte d'éléments susceptibles d'engendrer des réactions de corrosion avec le métal déposé.

En outre, la phase gazeuse du plasma ne doit pas non plus contenir des éléments ou composés pouvant nuire aux caractéristiques électriques du matériau polymère gravé.

Enfin, il est extrêmement souhaitable que l'étape de gravure puisse être mise en oeuvre en toute sécurité.

La présente invention a donc pour objet un procédé de gravure par plasma, en particulier par plasma à base d'oxygène, d'une couche de matériau polymère qui soit anisotrope, non corrosif et de préférence sans danger.

Selon l'invention, le procédé de gravure anisotrope d'une couche en matériau polymère diélectrique organique comprend la gravure anisotrope de la couche de polymère au moyen d'un plasma dont la phase gazeuse est constituée de O₂/NH₃, O₂/H₂O, O₂/CH₄ ou O₂/H₂.

Dans les mélanges gazeux cités, la concentration en O₂ est généralement inférieure à 40% en volume. En particulier, pour les mélanges O₂/NH₃ et O₂/H₂O, la concentration en O₂ est de préférence inférieure à 30% en volume pour le mélange O₂/NH₃ et 15% en volume pour le mélange O₂/H₂O. Les mélanges gazeux préférés sont O₂/NH₃ et O₂/H₂O en raison de leur faible dangerosité. De préférence encore, pour ces mélanges, la concentration en volume de O₂ peut varier de 15 à 30% pour le couple O₂/NH₃ et de 0 à 10% pour le couple O₂/H₂O, du fait de la présence d'oxygène dans la molécule d'eau.

Pour tous ces mélanges gazeux, on pourra éventuellement y rajouter une faible proportion d'azote (N₂), par exemple jusqu'à 40% en volume, de préférence jusqu'à 30% en volume.

On peut utiliser pour le procédé de gravure plasma selon l'invention, toute source de gravure classique telle que des sources RIE (Reactive ion etching) et plasma haute densité, en particulier toute source de gravure du type utilisé pour la gravure du silicium polycristallin (par exemple LAM TCP, commercialisée par la Société LAM ou Applied DPS, commercialisée par la Société Applied Materials). La puissance d'excitation est généralement du même ordre de grandeur que pour la gravure par plasma d'oxygène d'un substrat de silicium (400 à 500 W pour des substrats de 200 mm). Le substrat est généralement maintenu à la température ambiante (20°C). La pression totale de la phase gazeuse est généralement de 13,3 Pa à 5,5 kPa et inférieure à 0,7 kPa dans le cas d'une source plasma haute densité. Dans le cas d'une source plasma haute densité, la puissance de polarisation appliquée au porte-substrat est généralement supérieure à celle appliquée dans le cas de la gravure de grille en silicium, et est de 250 à 350 W.

Le procédé de l'invention peut s'appliquer à tout matériau polymère organique diélectrique connu utilisé classiquement pour l'isolation d'interconnexion dans le domaine de l'électronique et en particulier au matériau polymère organique ayant une constante diélectrique inférieure à 4, et de préférence de l'ordre de 3 ou moins.

La présente invention concerne également l'application du procédé de gravure anisotrope décrit ci-dessus pour la fabrication d'interconnexions métalliques, en particulier en cuivre ou aluminium, dans une structure de type damascène.

Cette structure damascène comprend dans un substrat en matériau polymère organique diélectrique, des couches d'arrêt et à la surface du substrat un masque dur, les couches d'arrêt et le masque dur étant configurés pour définir des trous et lignes d'interconnexion.

Selon l'invention, on grave la structure damascène en utilisant le procédé de gravure plasma selon l'invention, décrit ci-dessus, puis on procède au remplissage des trous et lignes d'interconnexion avec un métal tel que du cuivre. Ce remplissage peut s'effectuer classiquement par dépôt chimique en phase vapeur.

On achève alors la réalisation des interconnexions par une étape classique de planarisation par polissage mécano-chimique.

### EXEMPLE

On a réalisé des trous d'interconnexion en utilisant le procédé de gravure plasma de l'invention.

Le substrat était constitué de matériau polymère SILK®, commercialisé par DOW CHEMICAL et avait une épaisseur de 1 µm.

Le masque dur était constitué d'une couche de SiO₂ d'épaisseur 0,15 µm.

La gravure plasma a été réalisée dans les conditions suivantes :
Appareil utilisé : APPLIED DPS
Puissance d'excitation : 400 W
Puissance de polarisation du substrat : 300 W
Température du substrat: 20°C
Phase gazeuse O₂/NH₃ : 20/80 en volume
Pression : 0,66 Pa.

La gravure a duré 1,5 minute (avec un temps de surgravure de 40%).

On a obtenu des trous d'interconnexion d'un diamètre de 0,3 µm et de profondeur 1 µm, dont les flancs étaient parfaitement droits.

## Revendications

1. Procédé de gravure anisotrope d'un substrat en matériau polymère organique diélectrique au moyen d'un plasma, caractérisé en ce que la phase gazeuse du plasma est constituée de O₂/NH₃, O₂/H₂O, O₂/CH₄ ou O₂/H₂, la concentration en oxygène des mélanges gazeux étant inférieure à 40% en volume.

2. Procédé selon la revendication 1, caractérisé en ce que les mélanges gazeux comprennent en plus de l'azote (N₂).

3. Procédé selon la revendication 2, caractérisé en ce que la concentration en volume d'azote est au plus de 40% et mieux de 30%.

4. Procédé selon la revendication 1, caractérisé en ce que la concentration en volume de O₂ pour le couple O₂/NH₃ varie de 15% à moins de 30%.

5. Procédé selon la revendication 1, caractérisé en ce que la concentration en volume de O₂ pour le couple O₂/H₂O est égale ou inférieure à 10%.

6. Procédé selon l'une quelconque des revendications 1 à 5, caractérisé en ce que la pression de la phase gazeuse varie de 13,3 Pa à 5,5 kPa.

7. Procédé selon l'une quelconque des revendications précédentes, caractérisé en ce que le matériau polymère organique a une constante diélectrique inférieure à 4, de préférence égale à 3 ou moins.

8. Procédé de fabrication d'interconnexions métalliques dans une structure de type damascène, comprenant dans un substrat en matériau polymère organique diélectrique des couches d'arrêt et un masque dur sur une surface du substrat, les couches d'arrêt et le masque dur étant configurés et disposés pour définir des lignes et trous d'interconnexion, caractérisé en ce que le substrat est gravé par le procédé selon l'une quelconque des revendications 1 à 7, pour former dans le substrat des trous et des lignes d'interconnexion et en ce qu'il comprend le remplissage des lignes et des trous avec un matériau conducteur.

9. Procédé selon la revendication 8, caractérisé en ce que le matériau conducteur est le cuivre ou l'aluminium.

10. Procédé selon la revendication 8 ou 9, caractérisé en ce qu'il comprend en outre, après le remplissage des trous et des lignes, une étape de planarisation par polissage mécano-chimique.
